# EUROPÄISCHE PATENTANMELDUNG

(11) **EP 1 585 375 A1**
(43) Veröffentlichungstag der Anmeldung: **12.10.2005**
(21) Anmeldenummer: 05006328.8
(22) Anmeldetag: 23.03.2005
(51) Int. Cl.: H05K 3/28, H05K 5/06

(54) **Kunststoffspritzteil mit durch Kunststoffmasse umspritzter Leiterplatte**

(30) Priorität: 08.04.2004 US 820156
(71) Anmelder: VEGA Grieshaber KG, 77709 Wolfach (DE)
(72) Erfinder: Becherer, Frank, 77716 Haslach (DE)
(74) Vertreter: Patentanwälte Westphal, Mussgnug & Partner

(57) **Zusammenfassung**

Die Erfindung bezieht sich auf eine Leiterplatte mit zumindest einem Kontaktelement zum Anschließen eines Gegenkontaktelements, wobei das Kontaktelement an der Leiterplatte befestigt ist, und einer Kunststoffschicht, welche auf zumindest einer Seite der Leiterplatte aufgebracht ist, wobei das Kontaktelement von der Leiterplatte aus durch die Kunststoffschicht hindurchführt und aus dieser Kunststoffschicht zum Anschließen des Gegenkontaktelements heraustragt. Die Erfindung bezieht sich außerdem auf ein Kunststoff-Spritzteil mit einer solchen in Kunststoff eingespritzten Leiterplatte bzw. auf ein Verfahren zum Herstellen einer solchen Leiterplatte und zum Herstellen eines solchen Kunststoff-Spritzteils.

## Beschreibung

### Gebiet der Erfindung

Die Erfindung bezieht sich auf eine Leiterplatte, auf ein Kunststoffspritzteil mit einer Leiterplatte bzw. auf ein Verfahren zu deren Herstellung.

### Hintergrund der Erfindung

An Sensoren beispielsweise Vibrationssensoren und Füllstandsmessgeräten ist an einem eigentlichen Sensorelement ein Gehäuse angesetzt, wobei in dem Gehäuse elektronische Komponenten zur Steuerung und/oder Auswertung von Signalen des Sensors aufgenommen sind. Die elektronischen Komponenten sitzen üblicherweise auf einer Leiterplatte, welche Kontaktelemente zum Anschließen eines Gegenkontaktelements aufweist. Das Gegenkontaktelement kann zu weiteren Komponenten innerhalb dieser Anordnung oder zu einer externen Anordnung führen. Wichtig ist, dass die elektronischen Komponenten dicht umschlossen sind, d. h. zumeist flüssigkeits- und staubdicht umschlossen sein sollen.

Bekannt ist eine Leiterplatte mit zumindest einem bzw. mehreren Kontaktelementen zum Anschließen jeweils eines Gegenkontaktelements, wobei das Kontaktelement an der Leiterplatte befestigt ist. Um einen gewissen Schutz zu bieten, ist auch das Umgießen von Leiterplatten mit einem sogenannten "hotmelt"-Verguss bekannt, wobei die dabei aufgetragene Kunststoffschicht nur bis 80°C temperaturbeständig ist und weder hohe chemische noch hohe mechanische Festigkeiten aufweist. Vor dem Umgießen werden die Kontaktelemente an der Leiterplatte bzw. einem entsprechenden Leitermaterial befestigt. Dies erfolgt beispielsweise durch das Einpressen von durchstoßenden Kontaktelementen oder durch Einkleben der durchstoßenden Kontaktelemente, welche z. B. zur Adaption eines kundenseitigen Steckers als Gegenkontaktelement benötigt werden. Diese Leiterplatte dient innerhalb des Gehäuses angeordnet zum Anschließen von Elektronikkomponenten für eine Signalauswertung von beispielsweise einem Füllstandsmessgerät, wobei die Elektronikkomponenten ebenfalls in dem Gehäuse aufgenommen werden.

Eine Aufgabe der Erfindung besteht darin, eine Leiterplatte mit Kontaktelementen und einer Kunststoffschicht hinsichtlich der Beständigkeit und des Schutzes gegenüber äußeren Einflüssen zu verbessern.

Eine weitere Aufgabe besteht darin, ein Kunststoffspritzteil mit einer solchen Leiterplatte auf einfache Art und Weise herzustellen und zugleich einen verbesserten und insbesondere dauerhafteren Schutz gegenüber äußeren Einflüssen zu ermöglichen.

Eine weitere Aufgabe besteht darin, ein Verfahren zum Herstellen einer solchen Leiterplatte bzw. eines solchen Kunststoffspritzteils vorzuschlagen, welches eine möglichst einfache Herstellung ermöglicht.

Diese Aufgabe wird gelöst durch eine Leiterplatte bzw. einen Träger mit zumindest einem Kontaktelement zum Anschließen eines Gegenkontaktelements, wobei das Kontaktelement an der Leiterplatte befestigt ist, und mit einer Kunststoffschicht, welche auf zumindest einer Seite des Trägers bzw. der Leiterplatte aufgebracht ist, wobei das Kontaktelement von dem Träger aus durch die Kunststoffschicht hindurchführt und aus dieser Kunststoffschicht zum Anschließen des Gegenkontaktelements herausragt.

Außerdem wird die Aufgabe gelöst durch ein Kunststoffspritzteil mit einem Träger bzw. einer Leiterplatte, die zumindest ein Kontaktelement zum Anschließen eines. Gegenkontaktelements aufweist, wobei das Kontaktelement an dem Träger bzw. der Leiterplatte befestigt ist, und mit einer Kunststoffschicht, welche auf zumindest einer Seite des Trägers bzw. der Leiterplatte aufgebracht ist, wobei das Kontaktelement von dem Träger bzw. der Leiterplatte aus durch die Kunststoffschicht hindurchführt und aus dieser Kunststoffschicht zum Anschließen des Gegenkontaktelements herausragt.

Verfahrensgemäß wird die Aufgabe gelöst durch ein Verfahren zum teilweisen Umspritzen eines Trägers bzw. einer Leiterplatte, die zumindest ein Kontaktelement aufweist, wobei zum Umspritzen Kunststoff verwendet wird und wobei verfahrensgemäß das Kontaktelement am Träger bzw. an der Leiterplatte angelötet wird und danach der Träger bzw. die Leiterplatte derart mit dem Kunststoff umspritzt wird, dass das Kontaktelement von dem Träger bzw. der Leiterplatte aus durch den Kunststoff führt und zum Anschließen eines Gegenkontaktelements aus dem Kunststoff bzw. aus dessen Oberfläche herausragt.

Gemäß einer Vielzahl besonders bevorzugter Ausführungsformen ist diese Anordnung bzw. Verfahrensweise vorteilhaft ausgestaltbar.

Vorteilhafterweise kann die Kunststoffschicht ein- oder beidseitig auf den Träger aufgebracht sein bzw. werden. Besonders bevorzugt wird eine Kunststoffschicht aus einem thermoplastischen Material als Kunststoff mit einem Schmelzpunkt höher 80°C, insbesondere höher 100°C, wobei ein thermoplastisches Material mit einem Schmelzpunkt höher 350°C besonders bevorzugt wird, da dies eine hitzefeste und dauerhafte Abschirmung mit vorteilhaften Kunststoffmaterialien ermöglicht. Vorteilhafterweise besteht die Kunststoffschicht aus einem thermoplastischen Material mit einer Spritzgusstemperatur zwischen etwa 250 bis 410 °C, insbesondere zwischen 370° C und 410 °C, so dass ein Anlöten des zumindest einen Kontaktelements an der Leiterplatte mittels eines Hochtemperaturlots in Kombination mit dem Aufspritzen einer solchen Kunststoffschicht ermöglicht wird.

Bevorzugt wird eine Leiterplatte, bei der das Kontaktelement an der Leiterplatte angelötet ist bzw. in einer Durchgangsöffnung der Leiterplatte eingelötet ist, da dies eine besonders einfache Art der Befestigung ist, welche außerdem eine gute Haltbarkeit gegen Verbiegen oder axiales Verschieben bietet. Besonders bevorzugt wird, wenn das Kontaktelement an der Leiterplatte mit einem Hochtemperaturlot, insbesondere Hochtemperaturweichlot mit einer Schmelztemperatur höher 200°C, insbesondere höher 230°C angelötet ist bzw. wird. Dies ermöglicht ein anschließendes Überspritzen der Leiterplatte und des Lots mit einem thermoplastischen Material, welches eine Schmelztemperatur höher als 200°C oder gar höher als 350°C aufweist und optional eine Spritzgusstemperatur niedriger als der Schmelztemperatur des Hochtemperaturlots aufweist.

Insbesondere für die Beschichtung mit einem thermoplastischen Material wird vorteilhafterweise eine Leiterplatte aus einem Epoxid-Glashartgewebe mit vernetztem Harzsystem verwendet.

Zum Verbinden des zumindest einen Kontaktelements mit einem weiteren Kontaktelement oder sonstigen elektrischen oder elektronischen Komponenten dienen in üblicher Art und Weise Leiter bzw. Leiterbahnen, die auf der Oberfläche des Trägers angeordnet sind. Vorteilhafterweise werden ein solcher Leiter und ein dazu benachbarter Oberflächenbereich der Leiterplatte von der Kunststoffschicht abgedeckt. Die Kunststoffschicht muss somit nicht die gesamte Oberfläche der Leiterplatte abdecken, sollte aber vorzugsweise wesentliche oder alle auf der insbesondere außenseitigen Oberfläche der Leiterplatte angeordneten elektronischen Komponenten und Leiter abdecken.

Besonders bevorzugt werden Ausführungsformen, bei denen die Leiterplatte bzw. der Träger eine Durchgangsbohrung aufweisen, an bzw. in welcher das Kontaktelement angelötet ist, wobei auf den beiden einander gegenüberliegenden Oberflächen der Leiterplatte im Bereich der Durchgangsbohrung eine solche Kunststoffschicht aufgebracht ist bzw. aufgebracht wird. Insbesondere beim Aufbringen bzw.
Aufspritzen der Kunststoffschicht unter hohem Druck wird durch das beidseitige, insbesondere gleichzeitig beidseitige Aufspritzen des Kuststoffs eine Beschädigung des Lots im Bereich der Durchgangsbohrung vermieden.

### Kurze Beschreibung der Zeichnung

Ein Ausführungsbeispiel wird nachfolgend anhand der Zeichnung näher erläutert.

Es zeigen:
- Fig. 1: eine seitliche Schnittansicht einer Leiterplatte mit eingesetzten Kontaktelementen, wobei die Leiterplatte teilweise mit Kunststoff umspritzt ist;
- Fig. 2: eine Draufsicht auf die Anordnung gemäß Fig. 1 in teilweiser Schnittdarstellung; und
- Fig. 3: eine perspektivische Ansicht eines Gehäuseteils mit einer in Kunststoff eingespritzten Leiterplatte, wobei der Kunststoff zugleich zum Ausbilden einer Gehäusewand verwendet ist.

### Detaillierte Beschreibung eines erfinderischen Ausführungsbeispiels

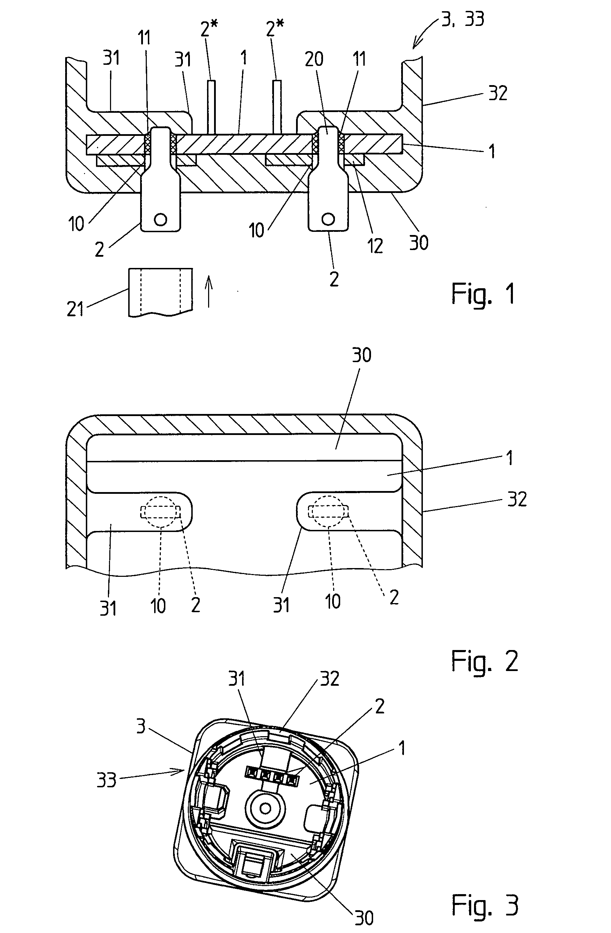

Wie aus den Figuren 1 - 3 ersichtlich, sind an einer Leiterplatte 1 Kontaktelemente 2 befestigt. Die Kontaktelemente 2 sind mit einem vorderseitigen Endabschnitt 20 durch jeweils eine Durchgangsöffnung 10 in der Leiterplatte bzw. dem Trägermaterial 1 hindurchgeführt. Zur Befestigung sind die Kontaktelemente 2 in den Durchgangsöffnungen 10 mit Lot 11 festgelötet. Das Lot 10 ragt teilweise in die Durchgangsöffnung 10 hinein oder auch durch diese zur anderen Seite der Leiterplatte 1 hindurch. Als Lot wird vorzugsweise ein Hochtemperaturlot verwendet.

Die Kontaktelemente 2 dienen in Art von Kontaktstiften zum Anschließen eines Gegenkontakt 21, beispielsweise eines Gegenkontakts 21 in Art einer Buchse, welche auf das Kontaktelement 2 aufgesteckt wird. Um an dem Gegenkontakt 21 angeschlossenen elektronische Komponenten mit weiteren elektronischen Komponenten zu verbinden, sind die Kontaktelemente 2 über das Lot 11 mit einer Leiterbahn als Leiter 12 verbunden, wobei die Leiterbahn 12 in üblicher Art und Weise auf der Oberfläche der Leiterplatte 1 angeordnet und befestigt ist. An die Leiterbahn 12 können elektronische Komponenten angeschlossen sein, welche direkt auf der Leiterplatte 1 angeordnet und ggf. umspritzt sind. Bei der dargestellten Ausführungsform sind an die Leiterbahnen 12 weitere Kontaktelemente 2* angeschlossen. Diese weiteren Kontaktelemente 2* dienen wiederum als Kontaktstifte zum Anschluss entsprechender Gegenkontaktelemente.

Die Anordnung aus der Leiterplatte 1 bzw. dem Träger und den daran befestigten Kontaktelementen 2, 2* ist mit einem Kunststoff 3 zumindest teilweise umspritzt. Der Kunststoff ist bei der dargestellten Ausführungsform als unterseitige Kunststoffschicht 30 auf eine erste Seitenfläche der Leiterplatte 1 aufgespritzt, wobei diese Seitenfläche der Leiterplatte 1 vollständig von der unterseitigen Kunststoffschicht 30 überzogen ist. Außerdem ist auf die gegenüberliegende Seite der Leiterplatte 1 abschnittsweise eine oberseitige Kunststoffschicht 31 aufgebracht bzw. aufgespritzt. Wie dargestellt, deckt die oberseitige Kunststoffschicht 31 Bereiche der Leiterplatte 1 ab, in welchen sich elektrische Komponenten wie die Kontaktelemente 2 sowie die Durchgangsöffnungen 10 zu der gegenüberliegenden Seite der Leiterplatte 1 befinden.

Zum Ausbilden eines Gehäuses 33 ragt von dem Kunststoff, mit welchem die Leiterplatte 1 umspritzt ist, Kunststoff seitlich weg, welcher eine Seitenwand 32 ausbildet. Durch eine solche Anordnung wird ein Gehäuse 33 zur Aufnahme von elektronischen Komponenten ausgebildet, wobei die elektronischen Komponenten innerhalb des durch die Leiterplatte 1 und die Seitenwand 32 gebildeten Raums aufgenommen werden. Der Anschluss solcher elektronischer Komponenten erfolgt über die Gegenkontaktelemente 21, welche an die Kontaktelemente 2 angeschlossen werden. Das derart ausgebildete Kunststoff-Spritzteil bildet somit ein Gehäuse 33 aus, wobei sämtliche elektronischen Komponenten einschließlich der Leiterplatte 1 vollständig von Kunststoff 3 umschlossen sind.

Um den Anschluss der Gegenkontaktelemente 21 an die Kontaktelemente 2, 2* zu ermöglichen, erstrecken sich die Kontaktelemente 2, 2* seitlich von der Leiterplatte 1 so weit weg, dass die Kontaktelemente 2, 2* mit ihren außenseitigen Endabschnitten aus dem Kunststoff 3, 30, 31 herausragen und kontaktierbar sind. Verfahrensgemäß wird daher nach dem Befestigen, insbesondere Anlöten der Kontaktelemente 2, 2* an der Leiterplatte 1 der Kunststoff 3 so aufgespritzt, dass die von der Leiterplatte 1 abgewandten Enden der Kontaktelemente 2, 2* ohne Kunststoffüberzug aus der entsprechenden Kunststoffschicht 30, 31 herausragen.

Gemäß einer besonders bevorzugten Ausführungsform wird der Kunststoff 3 auf der Seite der Leiterplatte 1, welche dem Raum zugewandt ist, der von der Seitenwand 30 umgrenzt wird, nur in Bereichen auf die Leiterplatte 1 aufgespritzt, in denen sich elektronische Komponenten, Kontaktelemente 2 und/oder Durchgangsöffnungen 10 befinden. Dabei erfolgt das Aufspritzen der Kunststoffschicht 31, 30 im Bereich von Durchgangsöffnungen 10 vorteilhafterweise nicht nur beidseitig sondern auch zur gleichen Zeit, um Beschädigungen des Lots 11 im Bereich der Durchgangsöffnungen 10 während des Aufspritzens unter hohem Druck zu vermeiden.

Als Kunststoff wird bevorzugt ein thermoplastisches Material verwendet, um eine besonders gute Dichtigkeit gegenüber Flüssigkeiten und Staub zu erzielen und um zugleich ein gegen mechanische Einwirkungen robustes Material für das Gehäuse 33 zu verwenden. Gemäß erster Versuche wurde als Kunststoff ein Polyetherimid (PEI) verwendet. Natürlich kann auch ein anderer Kunststoff insbesondere dieser Klasse zum Einsatz kommen, beispielsweise PSU, PES, PPSU, PPS etc. Bei all diesen Kunststoffen handelt es sich um Thermoplaste mit besonders vorteilhaften Eigenschaften. Die Schmelztemperatur liegt bei dem besonders bevorzugten Kunststoff je nach Bauteilausführung, d. h. Dicke und Dimensionierung der Gehäusewand 32 und Geometrie des Gehäuses vorzugsweise zwischen 370°C und 410°C. Jedoch können auch andere Kunststoffe mit höheren oder niedrigeren Schmelztemperaturen eingesetzt werden. Bei dem bevorzugt verwendeten Kunststoff PEI liegt die Spritztemperatur bei 370°C - 410°C. Gegenüber dem hotmelt-Verfahren, bei welchem mit Niederdruck im Bereich von 2 - 40 x 10⁵ Pa und der Temperatur der Schmelze von ca. 200°C gearbeitet wird, erfolgt das Aufspritzen des Kunststoffs gemäß dem bevorzugten Verfahren unter Drücken von bis zu 1500 x 10⁵ Pa und mehr.

Aufgrund der hohen Drücke beim Aufspritzen werden Bereiche der Leiterplatte 1 mit Lötstellen, insbesondere mit Lot 11 im Bereich von Durchgangsöffnungen 10 beidseitig umspritzt, d. h. sowohl von der Ober- als auch von der Unterseite der Leiterplatte 1 gleichzeitig, so dass Beschädigungen der Lötstellen durch den hohen Spritzdruck vermieden werden.

Damit mit derart hohen Temperaturen gearbeitet werden kann, wird bevorzugt ein Leiterplattenwerkstoff verwendet, welcher eine hohe Temperaturbeständigkeit aufweist. Vorteilhaft hat sich dabei ein Epoxid-Glashartgewebe gezeigt, insbesondere ein solches Epoxid-Glashartgewebe mit vernetztem Harzsystem und mit einer Glasübergangstemperatur größer 150°C.

Wegen der sehr hohen Temperaturen der Kunststoffschmelze beim Aufspritzen des Kunststoffs wird vorzugsweise ein Hochtemperaturweichl.ot verwendet. Bevorzugt wird dabei ein Hochtemperaturweichlot mit einer Schmelztemperatur höher 200°C, insbesondere höher 230°C oder 235°, bei dem besonders bevorzugten Kunststoff. Aufgrund der kurzen Kontaktzeit mit der heißen Schmelze und der raschen Abkühlung binnen Sekunden wird das Lot nicht aufgeschmolzen oder zumindest nicht vollständig aufgeschmolzen, obwohl die Kunststoffschmelze wesentlich heißer ist.

Bei Verwendung anderer Materialien werden die Materialien der übrigen Komponenten mit entsprechend geeigneten Werten verwendet.

Halbleiterkomponenten, welche aufgrund der hohen Temperaturen der Kunststoffschmelze beim Aufspritzen nicht komplett umspritzt werden können, können vorteilhafterweise auf Bereichen der Leiterplatte 1 angeordnet werden, welche von Kunststoff nicht umspritzt sind. Insbesondere die Kontaktelemente 2, 2*, die Leiter 12 und das Lot 11 können jedoch aufgrund der ausreichenden Hitzebeständigkeit komplett umspritzt werden.

Auf diese Art und Weise ist ein Kunststoffspritzteil als Gehäuse 33 zum dichten Aufnehmen von elektronischen Komponenten herstellbar. Nach dem Einsetzen elektronischer Komponenten kann das Gehäuse durch einen entsprechenden Deckel oder ein fortgesetztes Umspritzen mit einer entsprechenden zusätzlichen Wandung aus Kunststoff dicht geschlossen werden. Durch den Einsatz eines thermoplastischen Kunststoffmaterials und das Umspritzen der Leiterplatte mit den Kontaktelementen, welche innenseitig und außenseitig aus dem Kunststoff herausragen, wird ein Gehäuse 33 bereitgestellt, welches auch hohen mechanischen Anforderungen genügt. Die Kontaktelemente sind gegen Verbiegen oder axiales Verschieben relativ zur Wand des Gehäuses gesichert. Außerdem bietet das Gehäuse eine flüssigkeitsdichte und staubdichte Ummantelung des Innenraums mit elektronischen Komponenten. Vorteilhafterweise werden bei dieser Ausführung keine Kleber oder Dichtmittel eingesetzt, welche Beständigkeitsprobleme beim Einsatz des Gehäuses in Verbindung mit z. B. einem Füllstandsmessgerät hervorrufen würden. Aufgrund der einfachen Verfahrensweise ist auch eine kostengünstige Fertigung des Kunststoff-Spritzteils mit der derart umspritzten Leiterplatte möglich.

## Patentansprüche

1. Leiterplatte mit
- zumindest einem Kontaktelement zum Anschließen eines Gegenkontaktelements, wobei das Kontaktelement an der Leiterplatte befestigt ist, und
- einer Kunststoffschicht, welche auf zumindest einer Seite der Leiterplatte aufgebracht ist,
- wobei das Kontaktelement von der Leiterplatte aus durch die Kunststoffschicht hindurchführt und aus dieser Kunststoffschicht zum Anschließen des Gegenkontaktelements herausragt.

2. Leiterplatte nach Anspruch 1, bei der die Kunstoffschicht ein- oder beidseitig auf der Leiterplatte aufgebracht ist.

3. Leiterplatte nach Anspruch 1, bei der die Kunststoffschicht ein thermoplastisches Material mit einem Schmelzpunkt zwischen 250°C und 450°C ist., bevorzugt zwischen 350° bis 410 °C ist.

4. Leiterplatte nach Anspruch 3, bei der die Kunststoffschicht ein thermoplastisches Material mit einer mit einem Schmelzpunkt zwischen 350°C und 410°C ist.

5. Leiterplatte nach Anspruch 1, bei der das Kontaktelement an der Leiterplatte angelötet ist.

6. Leiterplatte nach Anspruch 1, bei der das Kontaktelement an der Leiterplatte mit einem Hochtemperaturlot mit einer Schmelztemperatur höher 200°C, insbesondere höher 230° angelötet ist.

7. Leiterplatte nach Anspruch 3, bei der das Kontaktelement an der Leiterplatte mit einem Hochtemperaturlot mit einer Schmelztemperatur höher 200°C, insbesondere höher 230° angelötet ist.

8. Leiterplatte nach Anspruch 1, bei der die Leiterplatte aus einem Leiterplattenwerkstoff mit einer Temperaturfestigkeit höher 100°C, insbesondere höher 150°C besteht.

9. Leiterplatte nach Anspruch 1, bei der die Leiterplatte aus einem Epoxid-Glashartgewebe mit vernetztem Harzsystem besteht.

10. Leiterplatte nach Anspruch 1, bei der zumindest ein Leiter auf einer Oberfläche der Leiterplatte angeordnet ist und die Kunststoffschicht den Leiter und einen dazu benachbarten Oberflächenbereich der Leiterplatte abdeckt.

11. Leiterplatte nach Anspruch 7, bei der zumindest ein Leiter auf einer Oberfläche der Leiterplatte angeordnet ist und die Kunststoffschicht den Leiter und einen dazu benachbarten Oberflächenbereich der Leiterplatte abdeckt.

12. Leiterplatte nach Anspruch 1, bei der die Leiterplatte eine Durchgangsbohrung aufweist, an welcher das Kontaktelement angelötet ist, und bei der auf den beiden einander gegenüberliegenden Oberflächen der Leiterplatte im Bereich der Durchgangsbohrung eine solche Kunststoffschicht aufgebracht ist.

13. Leiterplatte nach Anspruch 11, bei der die Leiterplatte eine Durchgangsbohrung aufweist, an welcher das Kontaktelement angelötet ist, und bei der auf den beiden einander gegenüberliegenden Oberflächen der Leiterplatte im Bereich der Durchgangsbohrung eine solche Kunststoffschicht aufgebracht ist.

14. Leiterplatte nach Anspruch 1,
- bei der die Kunstoffschicht ein- oder beidseitig auf der Leiterplatte aufgebracht ist,
- bei der die Kunststoffschicht ein thermoplastisches Material mit einem Schmelzpunkt höher 80°C, insbesondere höher 350°C ist,
- bei der das Kontaktelement an der Leiterplatte angelötet ist,
- bei der die Leiterplatte aus einem Epoxid-Glashartgewebe mit vernetztem Harzsystem besteht und
- bei der zumindest ein Leiter auf einer Oberfläche der Leiterplatte angeordnet ist und die Kunststoffschicht den Leiter und einen dazu benachbarten Oberflächenbereich der Leiterplatte abdeckt.

15. Kunststoffspritzteil mit
- einer Leiterplatte, die zumindest ein Kontaktelement zum Anschließen eines Gegenkontaktelements aufweist, wobei das Kontaktelement an der Leiterplatte befestigt ist, und
- einer Kunststoffschicht, welche auf zumindest einer Seite der Leiterplatte aufgebracht ist,
- wobei das Kontaktelement von der Leiterplatte aus durch die Kunststoffschicht hindurchführt und aus dieser Kunststoffschicht zum Anschließen des Gegenkontaktelements herausragt.

16. Kunststoffspritzteil nach Anspruch 15, bei dem sich Kunststoff von der Kunststoffschicht aus als Gehäusewand eines Gehäuses seitlich weg erstreckt und die Kunststoffschicht und die Gehäusewand aus dem gleichen Material gefertigt sind.

17. Kunststoff-Spritzteil nach Anspruch 15, bei dem
- die Kunstoffschicht ein- oder beidseitig auf der Leiterplatte aufgebracht ist,
- bei dem die Kunststoffschicht ein thermoplastisches Material mit einem Schmelzpunkt höher 80°C, insbesondere höher 350°C ist,
- bei dem das Kontaktelement an der Leiterplatte angelötet ist,
- bei dem die Leiterplatte aus einem Epoxid-Glashartgewebe mit vernetztem Harzsystem besteht und
- bei dem zumindest ein Leiter auf einer Oberfläche der Leiterplatte angeordnet ist und die Kunststoffschicht den Leiter und einen dazu benachbarten Oberflächenbereich der Leiterplatte abdeckt.

18. Verfahren zum zumindest teilweisen Umspritzen einer Leiterplatte, die zumindest ein Kontaktelement aufweist, mit Kunststoff, wobei bei dem Verfahren
- das Kontaktelement an der Leiterplatte angelötet wird und
- danach die Leiterplatte mit dem Kunststoff derart umspritzt wird, dass das Kontaktelement von der Leiterplatte aus durch den Kunststoff führt und zum Anschließen eines Gegenkontaktelements aus dem Kunststoff herausragt.

19. Verfahren nach Anspruch 18, bei dem das Kontaktelement in einer Durchgangsbohrung der Leiterplatte angelötet ist und der Kunststoff als Kunststoffschicht auf den beiden einander gegenüberliegenden Oberflächen der Leiterplatte im Bereich der Durchgangsbohrung gleichzeitig aufgespritzt wird.

20. Verfahren nach Anspruch 18, bei dem
- als Kunststoff ein thermoplastisches Material mit einer Schmelztemperatur höher 80°C, insbesondere höher 100°C, insbesondere höher 350°C verwendet wird,
- zum Anlöten des Kontaktelements ein Hochtemperaturlot mit einer Schmelztemperatur höher 200°C, insbesondere höher 235°C verwendet wird und
- eine Leiterplatte aus einem Leiterplattenwerkstoff mit einer Beständigkeit größer 150°C verwendet wird.
